# EUROPÄISCHE PATENTSCHRIFT

(11) **EP 3 893 270 B1**
(45) Veröffentlichungstag und Bekanntmachung des Hinweises auf die Patenterteilung: **19.07.2023**
(21) Anmeldenummer: 21164346.5
(22) Anmeldetag: 23.03.2021
(51) Int. Cl.: H01L 21/677, H01L 21/687, B25J 15/00, B25J 11/00, B25J 19/00

(54) **VORRICHTUNG UND VERFAHREN ZUM ENTNEHMEN EINES GERAHMTEN WAFERS AUS EINER WAFERABLAGE**
DEVICE AND METHOD FOR REMOVING A FRAMED WAFER FROM A WAFER TRAY
DISPOSITIF ET PROCÉDÉ D'ENLÈVEMENT D'UNE PLAQUETTE ENCADRÉE D'UN DÉPÔT DE PLAQUETTES

(30) Priorität: 08.04.2020 DE 102020109866
(43) Veröffentlichungstag der Anmeldung: 13.10.2021
(73) Patentinhaber: MUETEC Automatisierte Mikroskopie und Messtechnik GmbH, 80992 München (DE)
(72) Erfinder: AMMERL, Josef, 94130 Obernzell (DE); FRÖSCHL, Michael, 94533 Buchhofen Ottmaring (DE)
(74) Vertreter: Paustian, Othmar

(56) Entgegenhaltungen:
- EP-A2- 1 041 604
- CN-A- 102 738 056
- JP-A- 2017 076 679
- US-A1- 2006 192 400
- US-A1- 2008 224 491
- US-A1- 2008 304 942
- US-A1- 2011 187 140
- US-B1- 6 513 848

## Beschreibung

Die Erfindung bezieht sich auf eine Vorrichtung und ein Verfahren zum Entnehmen eines gerahmten Wafers aus einer Waferablage.

Eine solche Vorrichtung ist Teil eines Transportmechanismus, insbesondere eines Roboters, mit dem gerahmte Wafer von einer Waferablage zu einer Inspektionsvorrichtung transportiert werden. Die gerahmten Wafer werden dabei von einer Waferaufnahme des Transportmechanismus in der Waferablage übernommen und in der Inspektionsvorrichtung abgelegt. Um eine vollständige korrekte Inspektion der gerahmten Wafer zu gewährleisten, müssen diese in der Inspektionsvorrichtung eine definierte Soll Lage einnehmen. Es ist daher wünschenswert, dass die Waferaufnahme des Transportmechanismus die gerahmten Wafer in deren Soll- Lage in der Inspektionsvorrichtung ablegen. Es ist jedoch festgestellt worden, dass die gerahmten Wafer, selbst wenn sie in der Waferablage bereits in der korrekten Lage für ihre spätere Soll-Lage in der Inspektionsvorrichtung abgelegt waren, nach ihrem Transport diese Soll-Lage in der Inspektionsvorrichtung nicht mehr einnahmen.

Die EP 1 041 604 A2 offenbart eine Vorrichtung zum Entnehmen eines Wafers aus einer Waferablage, die einen Zugang zum Ablegen oder Entnehmen des Wafers aufweist. Eine Waferaufnahme ist dazu eingerichtet, den Wafer senkrecht zur Waferebene zu haltern und so der Waferablage zu entnehmen, und weist federnd gelagerte Waferaufnahme-Randkontaktelemente auf. Eine Antriebs- und Steuereinrichtung führt die Waferaufnahme längs einer vorgegebenen Bewegungsbahn in den Zugang der Waferablage hinein und aus diesem heraus. Dabei ist die Waferaufnahme von einer ersten Position, in der sich jedes Waferaufnahme-Randkontaktelement mit Abstand vordem Waferrand befindet, in eine zweite Position, in der jedes Waferaufnahme-Randkontaktelement an dem Waferrand anliegt, der gegenüberliegende Waferrand an Waferablage-Randkontaktelementen anliegt und die Federlagerung einiger Waferaufnahme-Randkontaktelemente gestaucht ist, und zurück verschiebbar.

Aus der JP 2017 076679 A ist eine Vorrichtung zum Entnehmen eines gerahmten Wafers aus einer Waferablage bekannt, die einen Zugang zum Ablegen oder Entnehmen des gerahmten Wafers aufweist, wobei der abgelegte gerahmte Wafer einen dem Zugang zugewandten vorderen Rahmenrand und die Waferablage ein Waferablage-Randkontaktelement zu Anlage an den rückwärtigen Rahmenrand aufweist. Eine Waferaufnahme zur Aufnahme des gerahmten Wafers ist dazu eingerichtet, den Wafer senkrecht zur Waferebene zu haltern und so der Waferablage zu entnehmen, und weist federnd gelagerte Waferaufnahme-Randkontaktelemente auf, die zur Anlage an den vorderen Rahmenrand angeordnet und eingerichtet sind. Eine Antriebes- und Steuereinrichtung führt die Waferaufnahme längs einer vorgegebenen Bewegungsbahn in den Zugang der Waferablage hinein und aus diesem heraus. Dabei ist die Waferaufnahme von einer ersten Position, in der sich jedes Waferaufnahme-Randkontaktelement mit Abstand vor dem vorderen Rahmenrand befindet, in eine zweite Position, in der jedes Waferaufnahme-Randkontaktelement an dem vorderen Rahmenrand anliegt und der rückwärtige Rahmenrand an dem Waferablage-Randkontaktelement anliegt, und zurück verschiebbar ist.

Die US 2011/187140 A1 zeigt eine Vorrichtung zur Aufnahme von Wafern, wobei ein Federelement angebracht ist, um den "Einschlag" der Schiebevorrichtung beim Erstkontakt des Randkontaktelements abzumildern.

Aufgabe der Erfindung ist es daher, den Transport gerahmter Wafer von der Waferablage zur Inspektionsvorrichtung so zu verbessern, dass die gerahmten Wafer in ihrer Soll-Lage in der Inspektionsvorrichtung abgelegt werden.

Erfindungsgemäß wird diese durch eine Vorrichtung gemäß Anspruch 1 und ein Verfahren gemäß Anspruch 8 gelöst.

Der Erfindung liegt die Erkenntnis zugrunde, dass bereits bei der Entnahme eines gerahmten Wafers aus der Waferablage eine Lageveränderung des gerahmten Wafers eintreten kann, so dass seine Ist-Lage nicht mehr mit seiner Soll-Lage übereinstimmt, d.h. nach seiner Entnahme seine Ist-Ausrichtung zur Waferaufnahme nicht mehr mit seiner Soll-Ausrichtung übereinstimmt. Als Ursache hierfür wurde gefunden, dass der gerahmte Wafer bei seiner Entnahme von der Waferaufnahme gegen die Rückwand der Waferablage gedrückt und dann zwischen Waferaufnahme und Rückwand eingespannt sein kann und sich dadurch etwas elastisch verformen kann. Fährt die Waferaufnahme dann mit dem gerahmten Wafer zurück, um aus der Waferablage herauszufahren, entspannt sich der gerahmte Wafer schlagartig und verspringt deshalb auf der Waferaufnahme und ändert somit seine Lage bzw. Ausrichtung auf der Waferaufnahme.

Durch die erfindungsgemäßen Maßnahmen ist es möglich, ein Einspannen eines gerahmten Wafers zwischen Waferaufnahme und Waferablage und damit seine elastische Verformung auf ein vorgegebenes Maß zu begrenzen und eine schlagartige Entspannung der elastischen Verformung zu vermeiden. Ein Verspringen des gerahmten Wafers auf der Waferaufnahme und somit eine ungewollte Lageänderung auf der Waferaufnahme werden auf diese Weise verhindert.

Dadurch, dass die Elemente der Waferaufnahme, die mit dem vorderen Rand des gerahmten Wafers in Kontakt kommen, in Bewegungsrichtung der Waferaufnahme federnd gelagert sind, kann die Kraft, mit der der zu entnehmende gerahmte Wafer mit seinem rückwärtigen Rand an das Waferablage-Randkontaktelement gedrückt wird, auf die Größe der Federkraft begrenzt werden.

Zum anderen wird beim Zurückfahren der Waferaufnahme zunächst die Stauchung der gefederten Lagerung entspannt, d. h. die Größe der Stauchung der gefederten Lagerung nimmt entsprechend der beim Zurückfahren der Waferaufnahme zurückgelegten Wegstrecke ab. Somit wird der entnommene gerahmte Wafer nicht schlagartig entlastet, sondern allmählich entsprechend der mit der allmählich abnehmenden Stauchung der gefederten Lagerung verbundenen allmählichen Abnahme der Federkraft. Die Geschwindigkeit der Abnahme, d. h. die Dauer, bis der gerahmte Wafer nicht mehr zwischen Waferaufnahme-Randkontaktelement und Waferablage-Randkontaktelement eingespannt ist und somit der gerahmte Wafer spannungsfrei auf der Waferaufnahme liegt, ist durch die Geschwindigkeit bestimmt, mit der die Waferaufnahme aus der Waferablage zurückfährt.

Wenn der vordere Rahmenrand mindestens zwei Rahmenrand-Kontaktelemente aufweist und alle Rahmenrand-Kontaktelemente auf einer Linie liegen, weist die erfindungsgemäße Vorrichtung ebenfalls mindestens zwei Waferaufnahme-Randkontaktelemente auf und liegen alle Waferaufnahme-Randkontaktelemente auf eine Linie, wobei diese Linie in einem vorgegebenen Winkel zur Bewegungsbahn verläuft und alle Waferaufnahme-Randkontaktelemente zur Anlage an Rahmenrand-Kontaktelemente angeordnet und eingerichtet sind. Mit diesen Maßnahmen ist es möglich, die Lage bzw. die Ausrichtung des gerahmten Wafers auf der Waferaufnahme bei dessen Übernahme von der Waferablage gewollt zu verändern, da die auf eine Linie liegenden Waferaufnahme-Randkontaktelemente bei ihrer Anlage an die Rahmenrand-Kontaktelemente den gerahmten Wafer längs dieser Linie ausrichten.

Wenn die Waferaufnahme nur ein einziges Waferaufnahme-Randkontaktelement aufweist, ist es auch denkbar, dass die Waferablage mindestens zwei Waferablage-Randkontaktelemente aufweist und alle Waferablage-Randkontaktelemente auf einer Linie liegen, wobei diese Linie in einem vorgegebenen Winkel zur Bewegungsbahn verläuft. In diesem Fall würde der hintere Rahmenrand des gerahmten Wafers mindestens zwei zweite Rahmenrand-Kontaktelemente aufweisen, wobei alle zweiten Rahmenrand-Kontaktelemente auf einer Linie liegen und alle Waferablage-Randkontaktelemente zur Anlage an zweite Rahmenrand Kontaktelemente angeordnet und eingerichtet sind. Hierdurch wird die Lage bzw. Ausrichtung des gerahmten Wafers auf der Waferaufnahme bei dessen Übernahme von der Waferablage längs dieser Linie ausgerichtet.

Dabei liegen vorzugsweise alle Waferaufnahme-Randkontaktelemente auf eine Linie, die senkrecht zur Bewegungsbahn verläuft. Hierdurch wird die konstruktive Ausbildung einer erfindungsgemäßen Vorrichtung wesentlich vereinfacht.

Besonders bevorzugt liegen dabei alle Waferaufnahme-Randkontaktelemente auf eine Linie, die horizontal verläuft. Diese Maßnahme ermöglicht eine weitere erhebliche Vereinfachung der konstruktiven Ausbildung.

In einer günstigen Weiterbildung der Erfindung weist mindestens eine Federlagerung einen biege- und/oder torsionselastischen Stab auf, der an einem Ende biege- und torsionssteif eingespannt ist und im Übrigen frei auskragt und an dessen anderen freien Ende ein Waferaufnahme-Randkontaktelement befestigt ist, wobei der Elastizitätsmodul, der Querschnitt und die freie Kraglänge des Stabes so aufeinander abgestimmt sind, dass das Waferaufnahme-Randkontaktelement mit einer vorgegebenen Federkonstanten in Richtung der Bewegungsbahn an dem Stab gelagert ist. Hierdurch wird eine zugleich äußerst einfache und robuste Federlagerung erreicht. Da sie nur wenige Einzelteile aufweist, ist ihr Montageaufwand gering und ihre Zuverlässigkeit im Betrieb auf Dauer gewährleistet.

Vorteilhafterweise läuft dabei der Stab parallel zur Ebene eines aufzunehmenden gerahmten Wafers. Der von einer erfindungsgemäßen Vorrichtung benötigte Bauraum wird hierdurch reduziert.

Vorzugsweise weist die Federlagerung eine Federkonstante auf, die im Bereich von 0,5 N/mm bis 5,0 N/mm, besonders bevorzugt im Bereich von 0,8 N/mm bis 3,0 N/mm und ganz besonders bevorzugt im Bereich von1,2 N/mm bis 2,0 N/mm liegt. Mit Federkonstanten in diesen Größenbereichen übt die Federlagerung auf den gerahmten Wafer eine Druckkraft aus, die einerseits groß genug ist, um ihn sicher von der Waferablage zu übernehmen und eventuell dabei auszurichten, jedoch andererseits nicht so groß ist, dass der gerahmte Wafer nennenswert elastisch verformt wird.

Die Erfindung wird nachfolgend anhand der Zeichnungen beispielsweise noch näher erläutert. Es zeigen:

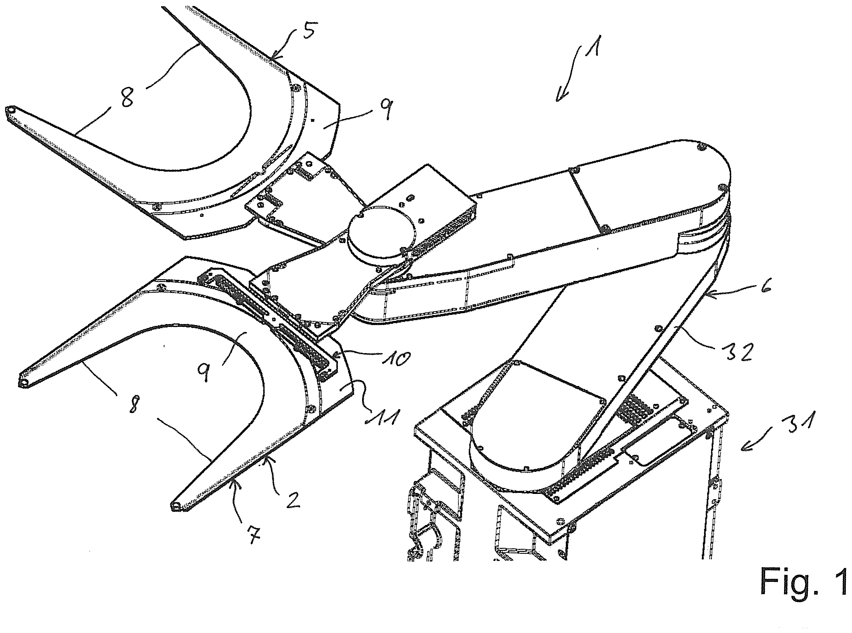

- Figur 1: in einer Perspektivansicht ein Ausführungsbeispiel einer erfindungsgemäßen Vorrichtung;

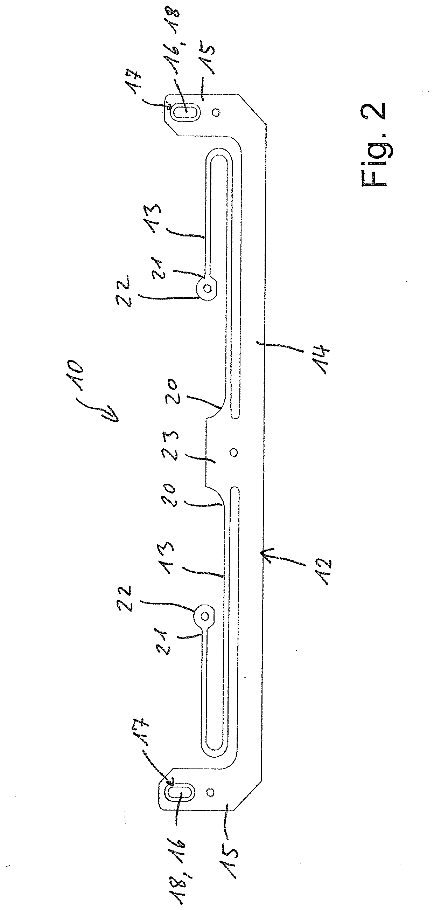

- Figur 2: eine Draufsicht auf das Bauteil "Federlagerung";

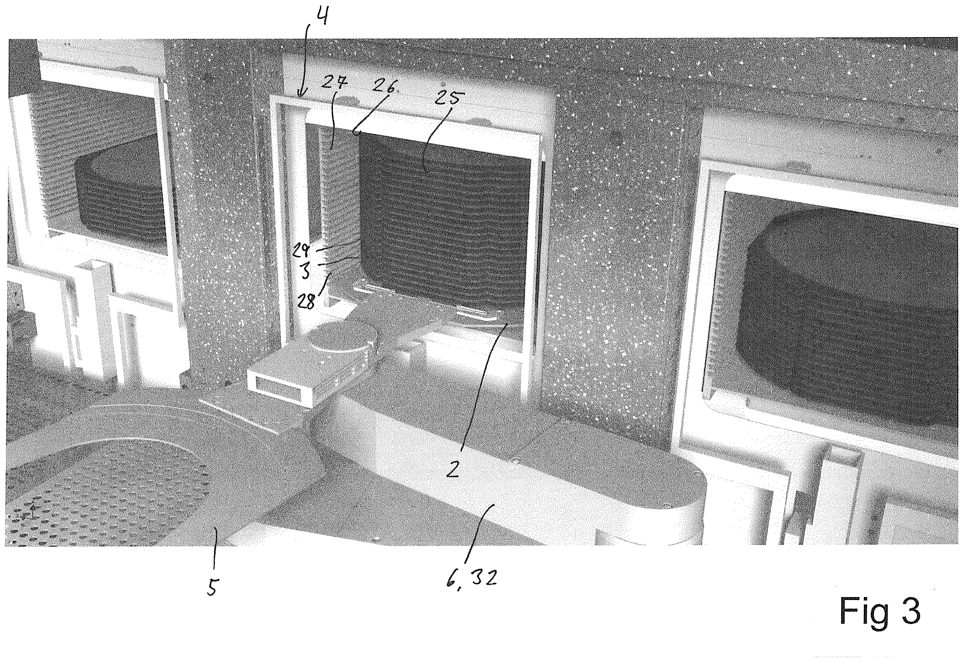

- Figur 3: in einer Perspektivansicht das Ausführungsbeispiel aus Figur 1 beim Entnehmen eines gerahmten Wafers aus einer Waferablage;
- Figur 4: eine Detailansicht aus Figur 3, wobei die Federlagerung ohne Druck an dem vorderen Rahmenrand des gerahmten Wafers anliegt und somit noch nicht gestaucht ist; und

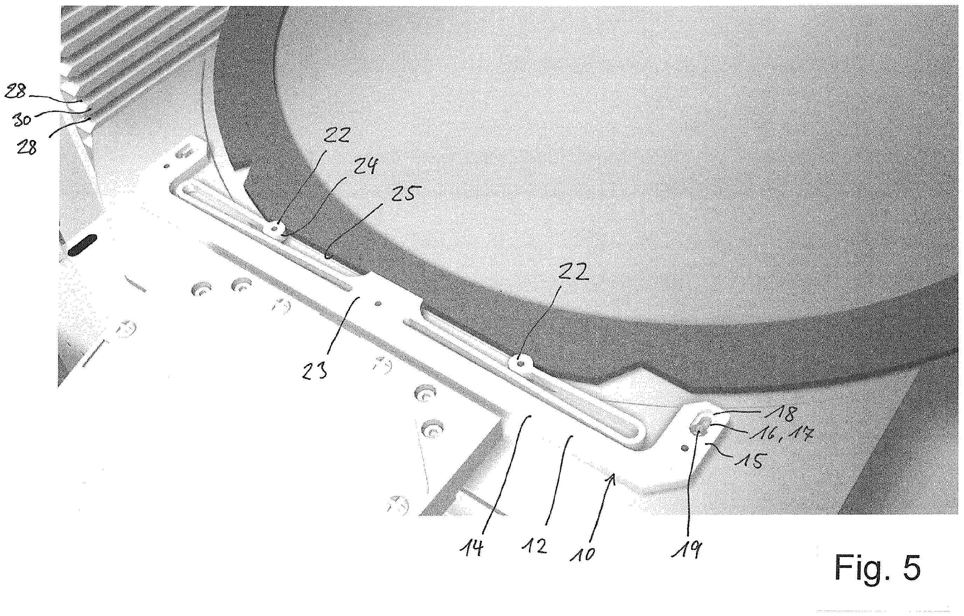

- Figur 5: eine ähnliche Detailansicht wie Figur 4, wobei die Federlagerung mit Druck an dem vorderen Rahmenrand des gerahmten Wafers anliegt und nunmehr gestaucht ist.

Das in den Figuren gezeigte Ausführungsbeispiel einer erfindungsgemäßen Vorrichtung 1 weist eine erste Waferaufnahme 2 zum Entnehmen eines gerahmten Wafers 3 aus einer Waferablage 4 und zu dessen Übergabe an eine (nicht dargestellte) Inspektionsvorrichtung sowie zusätzlich eine zweite Waferaufnahme 5 zur Entnahme des gerahmten inspizierten Wafers aus der Inspektionsvorrichtung und zu dessen Übergabe an eine Waferablage 4 sowie eine Antriebs- und Steuereinrichtung 6 zum jeweiligen Antrieb und zur jeweiligen Bewegungssteuerung der beiden Waferaufnahmen 2, 5 auf.

Die beiden Waferaufnahmen 2, 5 sind jeweils in Form einer Gabel 7 mit zwei Gabelzinken 8 bzw. U-förmig ausgebildet. Die Gabel 7 ist horizontal ausgerichtet, d.h. der gerahmte Wafer 3 liegt horizontal auf der jeweiligen Waferaufnahme 2, 5 auf und wird senkrecht zur Waferebene gehaltert und so der Waferablage 4 entnommen. Die beiden Waferaufnahmen 2, 5 sind jeweils an ihrer die beiden Gabelzinken 8 bzw. die beiden U-Schenkel verbindenden Basis 9 an der Antriebs- und Steuereinrichtung 6 befestigt, mit der jede Waferaufnahme 2, 5 längs einer vorgegebenen Bewegungsbahn bewegt wird.

Die erste Waferaufnahme 2 weist eine Federlagerung 10 auf. Sie ist auf der Oberseite 11 der ersten Waferaufnahme 2 auf deren Basis 9 befestigt. Die Federlagerung 10 weist einen verformungssteifen, starren Befestigungsabschnitt 12 und zwei Federelemente 13 auf. Mittels des Befestigungsabschnitts 12 ist zum einen die Federlagerung 10 auf der Oberseite 11 der ersten Waferaufnahme 2 befestigt. Zum anderen sind die beiden Federelemente 13 an dem Befestigungsabschnitt 12 befestigt, d. h. der Befestigungsabschnitt 12 dient als Widerlager, an dem sich die Federelemente 13 abstützen und gegenüber dem sie sich elastisch verformen.

Der Befestigungsabschnitt 12 weist einen länglichen Grundabschnitt 14 auf, der sich quer zu den Gabelzinken 8 in Richtung der Basis 9 der ersten Waferaufnahme 2 erstreckt. An jedem Ende des Grundabschnitts 14 ist ein kurzer Schenkel 15 ausgebildet, der sich in Richtung der Gabelzinken 8 erstreckt und Befestigungselemente 16 zur Befestigung des Befestigungsabschnitts 12 auf der Waferaufnahme 2 aufweist.

Außerdem weist der Befestigungsabschnitt 12 eine Stellvorrichtung 17 auf, mit der die Position und Ausrichtung der Federlagerung 10 auf der Waferaufnahme 2 einstellbar ist. Hierdurch kann z. B. bei einer vorgegebenen Bewegungsbahn der Waferaufnahme 2, insbesondere bei einem vorgegebenen Endpunkt der Bewegungsbahn in der Waferablage 4, die gewünschte Größe der Stauchung der Federlagerung 10 auf einfache Weise an die tatsächlichen örtlichen Gegebenheiten angepasst werden, indem die Federlagerung 10 auf der Waferaufnahme 2 in Richtung der Gabelzinken 8 vor- oder zurückpositioniert wird. Außerdem kann die gewünschte Winkelausrichtung des gerahmten Wafers 3 bei dessen Entnahme aus der Waferablage 4 voreingestellt werden, indem die Federlagerung 10 auf der Waferaufnahme 2 unter einem entsprechenden Winkel zur Bewegungsbahn der Waferaufnahme 2 befestigt wird.

Im dargestellten Ausführungsbeispiel ist diese Stellvorrichtung 17 als jeweils ein Langloch 18 in den beiden kurzen Schenkeln 15 des Befestigungsabschnitts 12 ausgebildet, wobei jedes Langloch 18 von einer Befestigungsschraube 19 durchlaufen wird, mit der die Federlagerung 10 auf der ersten Waferaufnahme 2 befestigt ist.

Die Federelemente 13 der Federlagerung 10 sind jeweils in Form eines frei auskragenden Stabes ausgebildet, der an einem ersten Ende 20 mit dem Befestigungsabschnitt 12 biege- und torsionssteif verbunden ist und an seinem zweiten, freien Ende 21 ein Waferaufnahme-Randkontaktelement 22 aufweist. Die Federelemente sind somit jeweils als Federstab 13 ausgebildet.

Der Befestigungsabschnitt 12 weist in der Mitte seines Grundabschnitts 14 in Richtung der Gabelzinken 8 einen Vorsprung 23 auf, an dem die ersten Enden 20 der Federstäbe 13 angeschlossen sind und der somit als Widerlager für die Federelemente 13 dient. Von diesem Vorsprung 23 aus erstrecken sich die Federstäbe 13 längs des Befestigungsabschnitts 12, bis sie in einem vorgegebenen Abstand vor dem jeweiligen kurzen Schenkel 15 des Befestigungsabschnitts 12 eine 180°-Biegung aufweisen und sich um ein vorgegebenes Maß wieder längs des Befestigungsabschnitts 12 in Richtung des Vorsprungs 23 erstrecken.

Die Waferaufnahme-Randkontaktelemente 22 sind in Form eines Kreisringes mit einem vorgegebenen Außendurchmesser und mit einer vorgegebenen Dicke senkrecht zur Kreisebene ausgebildet, wobei die Kreisebene parallel zur Ebene des zu entnehmenden Wafers 3, d. h. im vorliegenden Fall, horizontal verläuft. Die äußere Umfangsfläche 24 des Kreisrings dient zur Anlage an den vorderen Rahmenrand 25 des zu entnehmenden gerahmten Wafers 3.

Bei Anlage an den vorderen Rahmenrand 25 des zu entnehmenden Wafers 3 wird eine Drucckraft quer zur Längsachse des Federstabes 13 in diesen eingeleitet und bewirkt dessen elastische Biegeverformung. Die Federkonstante des Federstabes 13 ist maßgeblich durch dessen Elastizitätsmodul, Querschnitt und freie Kraglänge bestimmt.

Im Folgenden wird das Entnehmen eines gerahmten Wafers 3 aus einer Waferablage 4 mittels der erfindungsgemäßen Vorrichtung 1 beschrieben:
Dabei weist die Waferablage 4 einen Zugang 26 zum Entnehmen eines gerahmten Wafers 3 und ein in der Waferablage 4 abgelegter, zu entnehmender gerahmter Wafer 3 einen dem Zugang 26 zugewandten vorderen Rahmenrand 25 auf. Die Waferablage 4 weist zudem mindestens ein (nicht dargestelltes) Waferablage-Randkontaktelement auf, das zur Anlage an den (ebenfalls nicht dargestellten) rückwärtigen Rahmenrand des zu entnehmenden Wafers 3 angeordnet und eingerichtet ist.

Im dargestellten Ausführungsbeispiel weist die Waferablage 4 zwei einander gegenüberliegende vertikale Seitenwände 27 auf, die sich von dem vorderen, den Zugang 26 ausbildenden Ende der Waferablage 4 bis zu deren hinteren Ende, das das Waferablage-Randkontaktelement aufweist, erstrecken. Die Seitenwände 27 weisen jeweils mehrere übereinanderliegende und sich paarweise gegenüberliegende, horizontal vom vorderen zum hinteren Ende verlaufende Nuten 28 auf, in denen die gerahmten Wafer 3 mit ihren Seitenrändern 29 aufliegen. Der vertikale Abstand zwischen den Nuten 28 ist so gewählt, dass der Abstand zwischen den dort aufliegenden, abgelegten gerahmten Wafern 3 so groß ist, dass eine Waferaufnahme 2 zwischen die abgelegten Wafer 3 hineinfahren kann.

Die horizontale Breite der Waferaufnahme 2 ist so ausgelegt, dass die Waferaufnahme 2 zwischen die Stege 30, die benachbarte Nuten 28 voneinander trennen, hineingeführt werden kann.

Im dargestellten Ausführungsbeispiel ist die Vorrichtung 1 zur Entnahme eines gerahmten Wafers 3 aus der Waferablage 4 ein Roboter 31 mit einem Roboterarm 32, mittels dem die erste und die zweite Waferaufnahme 2, 5 entlang jeweiliger vorgegebener Bewegungsbahnen geführt werden.

Zur Entnahme eines gerahmten Wafers 3 aus der Waferablage 4 wird die erste Waferaufnahme 2 vor dem Zugang 26 der Waferablage 4 positioniert. Die erste Waferaufnahme 2 ist dabei etwas unterhalb des zu entnehmenden Wafers 3 positioniert, sodass sie in den Freiraum zwischen dem zu entnehmenden Wafer 3 und einem eventuell darunter abgelegten Wafer hineingeführt werden kann.

Die erste Waferaufnahme 2 wird nun in die Waferablage 4 hinein vorgeschoben, bis die erste Waferaufnahme 2 unter dem zu entnehmenden gerahmten Wafer 3 positioniert ist, und dann soweit angehoben, bis der zu entnehmende Wafer 3 zumindest auch auf der Waferaufnahme 2 aufliegt.

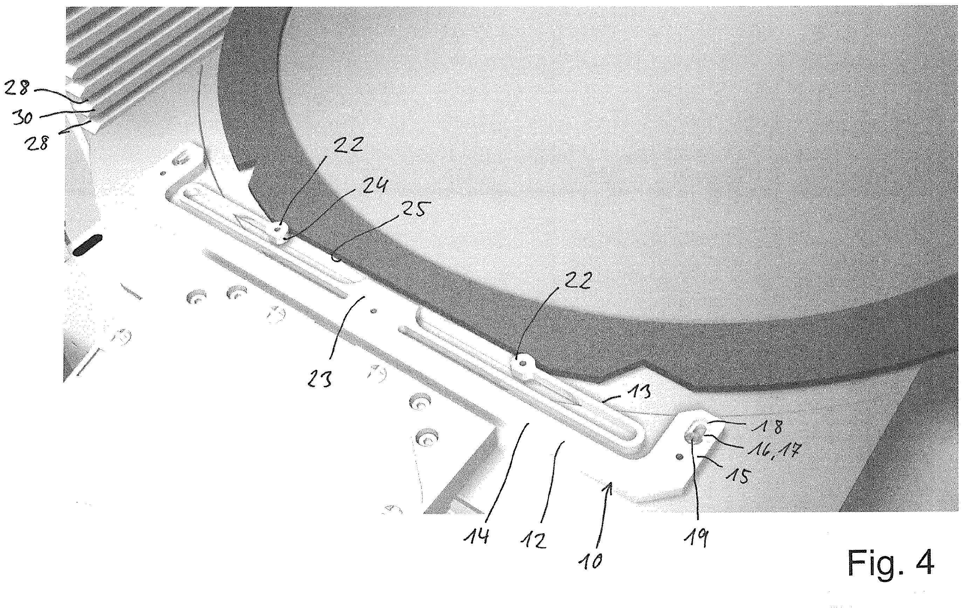

Die erste Waferaufnahme 2 wird nun weiter horizontal in die Waferablage 4 hinein vorgeschoben, bis alle Waferaufnahme-Randkontaktelemente 22 an dem vorderen Rahmenrand 25 des gerahmten Wafers 3 ohne Stauchung der Federlagerung 10 bzw. Federelemente 13 anliegen (Figur 4), und dann noch weiter vorgeschoben, bis der rückwärtige Rahmenrand des gerahmten Wafers 3 an dem mindestens einen Waferablage-Randkontaktelement anliegt und die Federlagerung 10 bzw. Federelemente 13 um ein vorgegebenes Maß gestaucht ist/sind, d. h. im dargestellten Ausführungsbeispiel die Federstäbe 13 um ein vorgegebenes Maß elastisch biegeverformt sind.

Die erste Waferaufnahme 2 wird nun aus der Waferablage 4 herausgeführt, d. h. rückwärts verschoben. Dabei kann die erste Waferaufnahme 2 noch etwas angehoben werden, d. h. ihre Bewegungsbahn etwas nach oben führen, damit - falls der gerahmte Wafer 3 auch noch in den Nuten 28 der Waferablage 4 aufgelegen hat - dieser nunmehr nur noch auf der ersten Waferaufnahme 2 und nicht mehr in den Nuten 28 der Waferablage 4 aufliegt

Durch das Zurückschieben der Waferaufnahme 2 wird die Federlagerung 10 der Waferaufnahme-Randkontaktelemente 22 wieder entlastet. Die Entlastungsgeschwindigkeit wird mittels der Geschwindigkeit gesteuert, mit der die Waferaufnahme 2 zurückverschoben wird. Dies bedeutet, dass die Druckkraft, mit der der zu entnehmende gerahmte Wafer 3 zwischen den Waferaufnahme-Randkontaktelementen 22 und dem mindestens einen Waferablage-Randkontaktelement eingespannt ist, entsprechend der Entlastungsgeschwindigkeit abnimmt und somit deren Abnahme steuerbar ist und eine schlagartige Abnahme vermeidbar ist. Ein Verspringen des zu entnehmenden Wafers 3 auf der Waferaufnahme 2 wird somit verhindert.

Nach vollständiger Entlastung der Federlagerung 10 kann dann der gerahmte Wafer 3 mit maximaler Geschwindigkeit aus der Waferablage 4 herausgeführt werden.

## Patentansprüche

1. Vorrichtung zum Entnehmen eines gerahmten Wafers (3) aus einer Waferablage (4), die einen Zugang (26) zum Ablegen oder Entnehmen des gerahmten Wafers (3) aufweist, wobei der abgelegte gerahmte Wafer ((3) einen dem Zugang 26) zugewandten vorderen Rahmenrand (25) und die Waferablage (4) mindestens ein Waferablage-Randkontaktelement zur Anlage an den rückwärtigen Rahmenrand aufweist, mit
einer Waferaufnahme (2) zur Aufnahme des gerahmten Wafers (3), die
- dazu eingerichtet ist, den Wafer (3) senkrecht zur Waferebene zu haltern und so der Waferablage (4) zu entnehmen, und
- mindestens ein Waferaufnahme-Randkontaktelement (22) aufweist, das zur Anlage an den vorderen Rahmenrand (25) angeordnet und eingerichtet sind, und mit
einer Antriebes- und Steuereinrichtung (6), die dazu eingerichtet ist, die Waferaufnahme (2) längs einer vorgegebenen Bewegungsbahn in den Zugang (26) der Waferablage (4) hineinzuführen und aus diesem herauszuführen,
wobei jedes Waferaufnahme-Randkontaktelement (22) in Richtung der Bewegungsbahn federnd gelagert ist und die Waferaufnahme (2) von einer ersten Position, in der sich jedes Waferaufnahme-Randkontaktelement (22) mit Abstand vor dem vorderen Rahmenrand (25) befindet, in eine zweite Position, in der jedes Waferaufnahme-Randkontaktelement (22) an dem vorderen Rahmenrand (25) anliegt, der rückwärtige Rahmenrand an dem Waferablage-Randkontaktelement anliegt und die Federlagerung (10, 13) jedes Waferaufnahme-Randkontaktelements (22) um einen vorgegebenen Federweg gestaucht ist, und zurück verschiebbar ist.

2. Vorrichtung nach Anspruch 1, wobei der vordere Rahmenrand 25) mindestens zwei Rahmenrand-Kontaktelemente aufweist und alle Rahmenrand-Kontaktelemente auf einer Linie liegen, **dadurch gekennzeichnet, dass** die Waferaufnahme (2) mindestens zwei Waferaufnahme-Randkontaktelemente (22) aufweist und alle Waferaufnahme-Randkontaktelemente (22) auf einer Linie liegen, wobei diese Linie in einem vorgegebenen Winkel zur Bewegungsbahn verläuft und alle Waferaufnahme-Randkontaktelemente (22) zur Anlage an Rahmenrand-Kontaktelemente angeordnet und eingerichtet sind.

3. Vorrichtung nach Anspruch 2, **dadurch gekennzeichnet, dass** alle Waferaufnahme-Randkontaktelemente (22) auf einer Linie liegen, die senkrecht zur Bewegungsbahn verläuft.

4. Vorrichtung nach Anspruch 2 oder 3, **dadurch gekennzeichnet, dass** alle Waferaufnahme-Randkontaktelemente (22) auf einer Linie liegen, die horizontal verläuft.

5. Vorrichtung nach einem der vorhergehenden Ansprüche, **dadurch gekennzeichnet, dass** mindestens eine Federlagerung (10) einen biege- und/oder torsionselastischen Federstab (13) aufweist, der an einem Ende (20) biege- und torsionssteif eingespannt ist und im Übrigen frei ausgekragt und an dessen anderen, freien Ende (21) ein Waferaufnahme-Randkontaktelement (22) befestigt ist, wobei der Elastizitätsmodul, der Querschnitt und die freie Kraglänge des Federstabes (13) so aufeinander abgestimmt sind, dass das Waferaufnahme-Randkontaktelement (22) mit einer vorgegebenen Federkonstanten in Richtung der Bewegungsbahn an dem Federstab (13) gelagert ist.

6. Vorrichtung nach Anspruch 5, **dadurch gekennzeichnet, dass** der Federstab (13) parallel zur Ebene eines aufzunehmenden gerahmten Wafers (3) verläuft.

7. Vorrichtung nach einem der vorhergehenden Ansprüche, **dadurch gekennzeichnet, dass** die Federlagerung (10,13) eine Federkonstante aufweist, die im Bereich von 0,5 N/mm bis 5,0 N/mm, bevorzugt im Bereich von 0,8 N/mm bis 3,0 N/mm und besonders bevorzugt im Bereich von 1,2 N/mm bis 2,0 N/mm liegt.

8. Verfahren zum Entnehmen eines gerahmten Wafers (3) aus einer Waferablage (4), die einen Zugang (26) zum Ablegen oder Entnehmen des gerahmten Wafers (3) aufweist, wobei der abgelegte gerahmte Wafer (3) einen dem Zugang (26) zugewandten vorderen Rahmenrand (25) und die Waferablage (4) mindestens ein Waferablage-Randkontaktelement zur Anlage an den rückwärtigen Rahmenrand aufweist, mit den folgenden Schritten:
- Bereitstellen einer Vorrichtung (1) gemäß einem der Ansprüche 1 bis 7;
- Positionieren der Waferaufnahme (2) vor dem Zugang (26) der Waferablage (4) des zu entnehmenden gerahmten Wafers (3);
- Verschieben der Waferaufnahme (2) längs der Bewegungsbahn, bis alle Waferaufnahme-Rand Kontaktelemente (22) am vorderen Rahmenrand (25) ohne Stauchung der Federlagerung (10, 13) anliegen;
- weiteres Verschieben der Waferaufnahme (2) längs der Bewegungsbahn, bis der rückwärtige Rahmenrand an dem mindestens einen Waferablage-Randkontaktelement anliegt und die Federlagerung (10, 13) jedes Waferaufnahme-Randkontaktelements (22) um ein vorgegebenes Maß gestaucht ist;
- Haltern des Wafers (3) senkrecht zur Waferebene mittels der Waferaufnahme (2);
- Zurückschieben der Waferaufnahme (2) längs der Bewegungsbahn, bis die Federlagerung (10, 13) jedes Waferaufnahme-Randkontaktelements (22) wieder entlastet ist;
- Herausführen des Wafers (3) aus der Waferablage (4) mittels der Waferaufnahme (2).

## Claims

1. A device for removing a framed wafer (3) from a wafer tray (4) that has an entrance (26) for depositing or removing the framed wafer (3), wherein the deposited framed wafer (3) has a front frame edge (25) facing the entrance (26) and the wafer tray (4) has at least one wafer tray edge contact element for contacting the rear frame edge, comprising
a wafer chuck (2) for accommodating the framed wafer (3), which
- is adapted to hold the wafer (3) perpendicularly to the wafer plane and thus remove it from the wafer tray (4), and
- has at least one wafer chuck edge contact element (22), which are arranged and adapted for contacting the front frame edge (25), and comprising
a drive and control device (6) that is adapted to guide the wafer chuck (2) into the entrance (26) of the wafer tray (4) and out of the same along a specified path of movement,
wherein each wafer chuck edge contact element (22) is spring mounted in the direction of the path of movement and the wafer chuck (2) can be shifted from a first position, in which each wafer chuck edge contact element (22) is located at a distance from the front frame edge (25), into a second position, in which each wafer chuck edge contact element (22) rests against the front frame edge (25), the rear frame edge rests against the wafer tray edge contact element, and the spring mount (10, 13) of each wafer chuck edge contact element (22) is compressed by a specified spring path, and back.

2. The device according to claim 1, wherein the front frame edge (25) has at least two frame edge contact elements and all frame edge contact elements lie on one line, **characterized in that** the wafer chuck (2) has at least two wafer chuck edge contact elements (22) and all wafer chuck edge contact elements (22) lie on one line, wherein this line extends at a specified angle to the path of movement and all wafer chuck edge contact elements (22) are arranged and adapted to rest against the frame edge contact elements.

3. The device according to claim 2, **characterized in that** all wafer chuck edge contact elements (22) lie on a line that extends perpendicularly to the path of movement.

4. The device according to claim 2 or 3, **characterized in that** all wafer chuck edge contact elements (22) lie on a line that extends horizontally.

5. The device according to any of the preceding claims, **characterized in that** at least one spring mount (10) includes a flexurally and/or torsionally elastic spring rod (13), which at one end (20) is clamped in a flexurally and torsionally rigid way and otherwise cantilevers freely, and at whose other, free end (21) a wafer chuck edge contact element (22) is attached, wherein the modulus of elasticity, the cross-section and the free cantilever length of the spring rod (13) are adjusted to each other such that the wafer chuck edge contact element (22) is mounted on the spring rod (13) with a specified spring constant in the direction of the path of movement.

6. The device according to claim 5, **characterized in that** the spring rod (13) extends parallel to the plane of a framed wafer (3) to be accommodated.

7. The device according to any of the preceding claims, **characterized in that** the spring mount (10, 13) has a spring constant that lies in the range of 0.5 N/mm to 5.0 N/mm, preferably in the range of 0.8 N/mm to 3.0 N/mm, and particularly preferably in the range of 1.2 N/mm to 2.0 N/mm.

8. A method for removing a framed wafer (3) from a wafer tray (4) that has an entrance (26) for depositing or removing the framed wafer (3), wherein the deposited framed wafer (3) has a front frame edge (25) facing the entrance (26) and the wafer tray (4) has at least one wafer tray edge contact element for contacting the rear frame edge, comprising the following steps:
- providing a device (1) according to any of claims 1 to 7;
- positioning the wafer chuck (2) in front of the entrance (26) of the wafer tray (4) of the framed wafer (3) to be removed;
- shifting of the wafer chuck (2) along the path of movement, until all wafer chuck edge contact elements (22) rest against the front frame edge (25) without compressing the spring mount (10, 13);
- further shifting of the wafer chuck (2) along the path of movement, until the rear frame edge rests against the at least one wafer tray edge contact element and the spring mount (10, 13) of each wafer chuck edge contact element (22) is compressed by a specified amount;
- holding the wafer (3) perpendicularly to the wafer plane by means of the wafer chuck (2);
- pushing the wafer chuck (2) back along the path of movement, until the spring mount (10, 13) of each wafer chuck edge contact element (22) is relieved again;
- guiding the wafer (3) out of the wafer tray (4) by means of the wafer chuck (2).

## Revendications

1. Dispositif d'enlèvement d'une plaquette encadrée (3) (dite « wafer ») d'un dépôt de plaquettes (4) qui présente un accès (26) pour déposer ou enlever la plaquette encadrée (3), la plaquette encadrée déposée (3) présentant un bord de cadre (25) avant tourné vers l'accès (26), et le dépôt de plaquettes (4) présentant au moins un élément de contact de bord de dépôt de plaquettes pour venir en appui contre le bord de cadre arrière, comprenant
un logement de plaquette (2) destiné à recevoir la plaquette encadrée (3), qui
- est conçu pour maintenir la plaquette (3) perpendiculairement au plan de la plaquette et pour la enlever ainsi de le dépôt de plaquettes (4), et
- comprend au moins un élément de contact de bord de logement de plaquette (22) qui est disposé et conçu pour venir en appui contre le bord de cadre (25) avant, et
un organe d'entraînement et de commande (6) qui est conçu pour insérer le logement de plaquette (2) dans l'accès (26) du dépôt de plaquettes (4) et pour l'extraire de celui-ci le long d'une trajectoire de déplacement prédéterminée,
chaque élément de contact de bord de logement de plaquette (22) étant supporté avec effet de ressort dans la direction de la trajectoire de déplacement, et le logement de plaquette (2) pouvant être déplacé, en va-et-vient, d'une première position, dans laquelle chaque élément de contact de bord de logement de plaquette (22) se trouve à distance devant le bord de cadre (25) avant, à une deuxième position, dans laquelle chaque élément de contact de bord de logement de plaquette (22) est en appui contre le bord de cadre (25) avant, le bord de cadre arrière est en appui contre l'élément de contact de bord de dépôt de plaquettes, et le support à ressort (10, 13) de chaque élément de contact de bord de logement de plaquette (22) est comprimé d'un trajet élastique prédéterminé.

2. Dispositif selon la revendication 1,
dans lequel le bord de cadre (25) avant présente au moins deux éléments de contact de bord de cadre, et tous les éléments de contact de bord de cadre se trouvent sur une ligne,
**caractérisé en ce que** le logement de plaquette (2) présente au moins deux éléments de contact de bord de logement de plaquette (22), et tous les éléments de contact de bord de logement de plaquette (22) se trouvent sur une ligne, cette ligne s'étendant selon un angle prédéterminé par rapport à la trajectoire de déplacement, et tous les éléments de contact de bord de logement de plaquette (22) étant disposés et conçus pour venir en appui contre des éléments de contact de bord de cadre.

3. Dispositif selon la revendication 2,
**caractérisé en ce que** tous les éléments de contact de bord de logement de plaquette (22) se trouvent sur une ligne qui est perpendiculaire à la trajectoire de déplacement.

4. Dispositif selon la revendication 2 ou 3,
**caractérisé en ce que** tous les éléments de contact de bord de logement de plaquette (22) se trouvent sur une ligne qui est horizontale.

5. Dispositif selon l'une des revendications précédentes,
**caractérisé en ce qu'**au moins un support à ressort (10) présente une barre de ressort (13) élastique en flexion et/ou en torsion, dont une extrémité (20) est serrée de manière rigide en flexion et en torsion et qui est par ailleurs en porte-à-faux libre, et dont l'autre extrémité (21) libre sert à fixer un élément de contact de bord de logement de plaquette (22), le module d'élasticité, la section transversale et la longueur de porte-à-faux libre de la barre de ressort (13) étant adaptés les uns aux autres de telle sorte que l'élément de contact de bord de logement de plaquette (22) est supporté sur la barre de ressort (13) avec une constante de rappel prédéterminée dans la direction de la trajectoire de déplacement.

6. Dispositif selon la revendication 5,
**caractérisé en ce que** la barre de ressort (13) s'étend parallèlement au plan d'une plaquette encadrée (3) à loger.

7. Dispositif selon l'une des revendications précédentes,
**caractérisé en ce que** le support à ressort (10, 13) présente une constante de rappel qui se situe dans la plage de 0,5 N/mm à 5,0 N/mm, de préférence dans la plage de 0,8 N/mm à 3,0 N/mm, et de manière particulièrement préférée dans la plage de 1,2 N/mm à 2,0 N/mm.

8. Procédé d'enlèvement d'une plaquette encadrée (3) d'un dépôt de plaquettes (4) qui présente un accès (26) pour déposer ou enlever la plaquette encadrée (3), la plaquette encadrée déposée (3) présentant un bord de cadre (25) avant tourné vers l'accès (26), et le dépôt de plaquettes (4) présentant au moins un élément de contact de bord de dépôt de plaquettes pour venir en appui contre le bord de cadre arrière, comprenant les étapes suivantes consistant à :
- fournir un dispositif (1) selon l'une des revendications 1 à 7 ;
- positionner le logement de plaquette (2) devant l'accès (26) du dépôt de plaquettes (4) de la plaquette encadrée (3) à enlever ;
- déplacer le logement de plaquette (2) le long de la trajectoire de déplacement jusqu'à ce que tous les éléments de contact de bord de logement de plaquette (22) soient en appui contre le bord de cadre (25) avant, sans comprimer le support à ressort (10, 13) ;
- continuer à déplacer le logement de plaquette (2) le long de la trajectoire de déplacement jusqu'à ce que le bord de cadre arrière soit en appui contre ledit au moins un élément de contact de bord de dépôt de plaquette et que le support à ressort (10, 13) de chaque élément de contact de bord de logement de plaquette (22) soit comprimé d'une valeur prédéterminée ;
- maintenir la plaquette (3) perpendiculairement au plan de la plaquette à l'aide du logement de plaquette (2) ;
- reculer le logement de plaquette (2) le long de la trajectoire de déplacement jusqu'à ce que le support à ressort (10, 13) de chaque élément de contact de bord de logement de plaquette (22) soit à nouveau déchargé ;
- extraire la plaquette (3) du dépôt de plaquettes (4) à l'aide du logement de plaquette (2).
